# EUROPEAN PATENT APPLICATION

(11) **EP 2 624 326 A2**
(43) Date of publication of application: **07.08.2013**
(21) Application number: 11829477.6
(22) Date of filing: 28.06.2011
(51) Int. Cl.: H01L 51/56, G02F 1/1333, G02F 1/167, H01L 29/786

(54) **METHOD FOR MANUFACTURING A FLEXIBLE ELECTRONIC DEVICE USING A ROLL-SHAPED MOTHERBOARD, FLEXIBLE ELECTRONIC DEVICE, AND FLEXIBLE SUBSTRATE**

(30) Priority: 29.09.2010 KR 20100094349
(71) Applicant: Posco, Pohang Kyungsangbook-do 790-300 (KR)
(72) Inventor: LEE, JongLam, Pohang-si Gyeongsangbuk-do 790-751 (KR); KIM, Kee Soo, Pohang-si Gyeongsangbuk-do 790-784 (KR)
(74) Representative: Zech, Stefan Markus
(86) International application number: PCT/KR2011/004694
(87) International publication number: WO 2012/043971

(57) **Abstract**

The present invention solves the problems of low performance and low yield of flexible electronic devices due to a low processing temperature, high surface roughness, high thermal expansion coefficient, and poor handling characteristics. A method of manufacturing a flexible electronic device includes forming a flexible substrate on a roll-type mother substrate, separating the flexible substrate from the roll-type mother substrate, and forming an electronic device on a separation surface of the flexible substrate, which has contacted the roll-type mother substrate

## Description

### [Technical Field]

The present invention relates to a method of manufacturing a flexible electronic device, a flexible electronic device manufactured by the method, and a flexible substrate used for a flexible electronic device, and more particularly, to a flexible electronic device including a flexible substrate having a novel structure which allows for a high processing temperature at the same level as a glass substrate and has low surface roughness, a low thermal expansion coefficient, and excellent handling characteristics, and a method of manufacturing the same.

### [Background Art]

With the development of multimedia, flexible electronic devices are becoming more important. Accordingly, it is necessary to manufacture organic light emitting displays (OLEDs), liquid crystal displays (LCDs), electrophoretic displays (EPDs), plasma display panels (PDPs), thin-film transistors (TFTs), microprocessors, and random access memories (RAMs) on flexible substrates.

In particular, it has become an important issue to develop a technology for manufacturing active matrix OLEDs (AMOLEDs), a display having the highest possibility of being made flexible and having excellent characteristics, at a high yield rate using an existing polysilicon TFT process.

Regarding a method of manufacturing an electronic device using a flexible substrate, three different methods, i.e. a method of directly manufacturing an electronic device on a plastic substrate, a method of using a transfer process, and a method of directly manufacturing an electronic device on a metal substrate, have been proposed.

Regarding the method of directly manufacturing an electronic device on a plastic substrate, Korean Patent Application Laid-open Publication No. 2009-0114195 discloses that a flexible substrate composed of polymeric materials is bonded to a glass substrate, and then an electronic device is manufactured and is separated from the glass substrate, while Korean Patent Application Laid-open Publication No. 2006-0134934 discloses that plastic is coated on a glass substrate using a spin-on method, and then an electronic device is manufactured and is separated from the glass substrate so as to manufacture a flexible electronic device.

However, according to the above-mentioned published patent applications, since a substrate is composed of plastic, an available processing temperature is 100-350 °C. However, it is necessary to perform heat treatment at a temperate of 450 °C or above, a crystallization temperature of silicon, in order to manufacture AMOLEDs, RAMs, and microprocessors. Therefore, these devices cannot be manufactured using plastic substrates. Further, during a manufacturing process, a defect such as a crack or exfoliation occurs due to a thermal expansion coefficient difference between an inorganic semiconductor such as Si, SiO₂, or SiN and plastic of an insulator and substrate, thereby degrading a yield.

Regarding the method using a transfer process, Korean Patent Application Laid-open Publication No. 2004-0097228 discloses that a separation layer, a thin-film device, a bonding layer, and a temporary substrate are sequentially formed on a glass substrate, and then light such as a laser is radiated to the separation layer so that the glass substrate is separated from a layer that is a subject of transfer.

However, in the case of the transfer process, since the thin-film device is thin, a double transfer process is necessary to bond the temporary substrate on the thin-film device and remove the temporary substrate after forming a device. According to this method, since the temporary substrate is bonded on the thin-film device and then is separated therefrom, interfacial bonding strength is weak, and this method cannot be applied to an organic electronic device such as an OLED that is vulnerable to moisture or solvent. Further, during processes of bonding and removing the glass substrate and the temporary substrate, the thin-film device may crack and impurities may be mixed, thereby degrading a yield.

Regarding the method using a metal substrate, Korean Patent Application Laid-open Publication No. 2008-0024037 discloses a method of providing flexible electronic devices at a high production yield by decreasing surface roughness through a buffer layer including glass on a metal substrate, Korean Patent Application Laid-open Publication No. 2009-0123164 discloses a method of improving a yield by removing an embossed pattern on a metal substrate through a polishing process, and Korean Patent Application Laid-open Publication No. 2008-0065210 discloses a method of forming an exfoliation layer and a metal layer on a glass substrate.

However, a thick-film metal substrate with a thickness of 15-150 µm used for a flexible electronic device has surface roughness of at least several hundred nm due to a manufacturing method of the substrate. For instance, in the case of a metal thick film manufactured through a rolling process, a trail of rolling remains. In the case of a metal thick film formed through deposition on a glass substrate, surface roughness increases in proportion to a thickness of the metal thick film, and thus varies depending on a deposition method and condition. Thus, it is difficult to manufacture a flexible metal substrate having low surface roughness. Therefore, according to the related art, it is necessary to apply a polymeric planarizing layer on a metal substrate or perform a polishing process in order to decrease surface roughness of the metal substrate. However, in the case of decreasing surface roughness by using polymeric materials, a high temperature process cannot be performed as mentioned above with respect to a plastic substrate process. A polishing process may be appropriate for a high-priced microprocessor or RAM using a single crystal Si substrate, but is not appropriate for a flexible electronic device requiring a large area in terms of economic feasibility.

### [Disclosure]

### [Technical Problem]

An aspect of the present invention provides a method of manufacturing a flexible electronic device, including a method of manufacturing a flexible substrate having low surface roughness so as to obtain the same device characteristics as a glass substrate process of the related art.

Another aspect of the present invention provides a method of manufacturing a high-performance flexible electronic device, in which a process of high temperature that is the same as or higher than that of a glass substrate process of the related art may be applied.

Another aspect of the present invention provides a method of manufacturing a metal substrate for a flexible electronic device, the metal substrate having a low thermal expansion coefficient so as to prevent a defect such as a crack or exfoliation which occurs due to a thermal expansion coefficient difference between a substrate and a device formed thereon.

Another aspect of the present invention provides a method of manufacturing a metal substrate for a flexible electronic device by applying characteristics of a flexible substrate to a roll-to-roll process for a high production rate and mass production.

### [Technical Solution]

According to an aspect of the present invention, there is provided a method of manufacturing a flexible electronic device, the method including forming a flexible substrate on a roll-type mother substrate, separating the flexible substrate from the roll-type mother substrate, and forming an electronic device on a separation surface of the flexible substrate, which has contacted the roll-type mother substrate.

According to the flexible electronic device manufacturing method of the present invention, a flexible substrate is formed on a surface of a roll-type mother substrate that has very row surface roughness and may be repeatedly used, and then the flexible substrate is separated from the roll-type mother substrate. Then, a separation surface of the flexible substrate may have a surface state that is very similar to that of a surface of the roll-type mother substrate. Therefore, application of polymeric materials for decreasing surface roughness is not necessary. Therefore, a high-performance electronic device may be implemented through a high-temperature process, and a problem of high cost of a polishing process and a low yield problem may be solved, thereby improving economic feasibility.

According to the flexible electronic device manufacturing method of the present invention, a roll-to-roll process to which a roll-type mother substrate is applied is used. Therefore, a flexible substrate may be transported, while being wound around the roll-type mother substrate. Further, processes of producing and transporting a substrate and forming an electronic device may be successively performed, as necessary, thereby improving a production rate and economic feasibility.

According to the flexible electronic device manufacturing method of the present invention, since a metal substrate is used, an existing glass substrate process, performed at a high temperature of 450 °C or above, and existing equipment may be used without experiencing problems of bending, transporting, and alignment of a substrate.

According to another aspect of the present invention, there is provided a method of manufacturing a flexible electronic device, the method including: forming a flexible substrate on a roll-type mother substrate, bonding a temporary substrate to the flexible substrate by using a bonding layer, the bonding layer being formed on one surface of the temporary substrate, separating the flexible substrate from the roll-type mother substrate, and forming an electronic device on a separation surface of the flexible substrate, which has contacted the roll-type mother substrate.

According to the flexible electronic device manufacturing method of the present invention, an exfoliation layer may be additionally formed between the flexible substrate and the roll-type mother substrate. Even though the thin exfoliation layer is added between the flexible substrate and the roll-type mother substrate, surface roughness of the separation surface of the flexible substrate may be similar to that of a surface of the roll-type mother substrate, since surface roughness of the exfoliation layer may be similar to that of the roll-type mother substrate. In the case of adding the exfoliation layer, the flexible substrate or the roll-type mother substrate may be prevented from being damaged when it is difficult to separate the flexible substrate from the roll-type mother substrate due to materials used therefore. Further, the exfoliation layer may have a multilayer composite structure in which different materials are stacked.

According to the flexible electronic device manufacturing method of the present invention, a planarizing layer may be additionally formed between the flexible substrate and the roll-type mother substrate, and a planarizing layer may be additionally formed on one or both surfaces of the exfoliation surface.

Since the planarizing layer is applied to the roll-type mother substrate instead of the flexible substrate, even though the planarizing layer is composed of a polymeric compound, the planarizing layer does not affect a temperature for manufacturing an electronic device and helps the flexible substrate to maintain a low degree of surface roughness. Any material capable of maintaining a low degree of surface roughness may be used for the planarizing layer. The planarizing layer may include at least one polymeric compound selected from the group consisting of polyimide (PI) or a copolymer comprising PI, polyacrylic acid or a copolymer comprising polyacrylic acid, polystyrene or a copolymer comprising polystyrene, polysulfate or a copolymer comprising polysulfate, polyamic acid or a copolymer comprising polyamic acid, polyamine or a copolymer comprising polyamine, polyvinylalcohol (PVA), polyallyamine, and polyacrylic acid.

According to the flexible electronic device manufacturing method of the present invention, a separation layer including at least one thin film may be formed between the temporary substrate and the bonding layer in order to facilitate separation of the temporary substrate.

According to the flexible electronic device manufacturing method of the present invention, surface roughness of a surface of the roll-type mother substrate, on which the flexible substrate is formed, may be 0 < Rₘₛ < 100 nm and 0 < Rₚ₋ᵥ < 1000 nm when measured with a scan range of 10 µm × 10 µm by using a surface roughness measuring device such as an atomic force microscope (AFM) or a 3-D profiler. If the surface roughness is outside of this range, the surface roughness of the separation surface of the flexible substrate increases, and thus it may be difficult to implement a high quality electronic device without performing an additional polishing process.

According to the flexible electronic device manufacturing method of the present invention, the roll-type mother substrate may be composed of at least one selected from the group consisting of glass, metal, and polymeric material.

Here, the glass may include at least one material selected from the group consisting of silicate glass, borosilicate glass, phosphate glass, fused silica glass, quartz, sapphire, E2K, and Vycor.

The metal may include at least one metal selected from the group consisting of Fe, Ag, Au, Cu, Cr, W, Al, W, Mo, Zn, Ni, Pt, Pd, Co, In, Mn, Si, Ta, Ti, Sn, Zn, Pb, V, Ru, Ir, Zr, Rh, Mg, INVAR, and steel use stainless (SUS) or an alloy thereof.

The polymeric material may include at least one polymeric compound selected from the group consisting of polyimide (PI) or a copolymer comprising PI, polyacrylic acid or a copolymer comprising polyacrylic acid, polystyrene or a copolymer comprising polystyrene, polysulfate or a copolymer comprising polysulfate, polyamic acid or a copolymer comprising polyamic acid, polyamine or a copolymer comprising polyamine, polyvinylalcohol (PVA), polyallyamine, and polyacrylic acid.

According to the flexible electronic device manufacturing method of the present invention, the flexible substrate may be composed of metal.

The metal of the flexible substrate may include at least one metal selected from the group consisting of Fe, Ag, Au, Cu, Cr, W, Al, W, Mo, Zn, Ni, Pt, Pd, Co, In, Mn, Si, Ta, Ti, Sn, Zn, Pb, V, Ru, Ir, Zr, Rh, Mg, INVAR, and steel use stainless (SUS) or an alloy thereof. In particular, in the case of an INVAR alloy, a thermal expansion coefficient may be adjusted to a similar level in comparison with an inorganic semiconductor such as Si, SiO₂, and SiN and insulator. Therefore, it is not necessary to change processing conditions such as a temperature increase rate or a temperature decrease rate, and cracks due to a thermal expansion coefficient difference may be reduced.

According to the flexible electronic device manufacturing method of the present invention, the flexible substrate may be formed through a casting process, an electron-beam evaporation process, a thermal deposition process, a sputter deposition process, a chemical vapor deposition process, or an electroplating process.

According to the flexible electronic device manufacturing method of the present invention, the electronic device may be at least one selected from the group consisting of an organic light-emitting display (OLED), a liquid crystal display (LCD), an electrophoretic display (EPD), a plasma display panel (PDP), a thin-film transistor (TFT), a microprocessor, and a random access memory (RAM).

According to the flexible electronic device manufacturing method of the present invention, the bonding layer may include at least one material selected from the group consisting of SiO₂, MgO, ZrO₂, Al₂O₃, Ni, Al, and mica, and a using temperature of the bonding layer is about 450 °C or above. The bonding layer may include at least one polymeric adhesive selected from the group consisting of epoxy, silicon, and acrylic group.

According to another aspect of the present invention, there is provided a flexible electronic device manufactured by the above-mentioned flexible electronic device manufacturing method.

According to another aspect of the present invention, there is provided a flexible substrate using a separation surface as a forming surface of an electronic device, wherein the separation surface is obtained by forming the flexible substrate on a roll-type mother substrate and then separating the flexible substrate from the roll-type substrate.

In the flexible substrate according to the present invention, surface roughness of the separation surface is, without undergoing a polishing process, 0 < Rₘₛ < 100 nm and 0 < Rₚ₋ᵥ < 1000 nm when measured with a scan range of 10 µm × 10 µm by using an atomic force microscope (AFM).

The flexible substrate according to the present invention may be composed of metal that may include at least one metal selected from the group consisting of Fe, Ag, Au, Cu, Cr, W, Al, W, Mo, Zn, Ni, Pt, Pd, Co, In, Mn, Si, Ta, Ti, Sn, Zn, Pb, V, Ru, Ir, Zr, Rh, Mg, INVAR, and steel use stainless (SUS) or an alloy thereof. In particular, an INVAR alloy capable of adjusting a thermal expansion coefficient to a very low level may be used.

The flexible substrate according to the present invention may be formed to a thickness of about 1 µm to about 500 µm.

According to the flexible substrate of the present invention, the electronic device may be at least one selected from the group consisting of an organic light-emitting display (OLED), a liquid crystal display (LCD), an electrophoretic display (EPD), a plasma display panel (PDP), a thin-film transistor (TFT), a microprocessor, and a random access memory (RAM).

### [Advantageous Effects]

A flexible electronic device manufacturing method, a flexible electronic device, and a flexible substrate, according to the present invention, can bring about the following effects, and are thus expected to contribute to manufacturing of high-performance flexible electronic devices at low cost.

First, by forming an electronic device on a separation surface having substantially the same surface roughness as a roll-type mother substrate, the problem of surface roughness of a flexible substrate, particularly, a metal flexible substrate, which could not be solved by an existing method of manufacturing a flexible electronic device, can be easily solved.

Second, since surface roughness of a flexible substrate can be maintained at a very low level, a polymeric planarizing layer which decreases a processing temperature to 350 °C or less is not necessary. Therefore, process time and cost can be saved. Further, a high-performance electronic device such as a polysilicon TFT may be manufactured through a process of high temperature of 450 °C or above.

Third, to manufacture a flexible substrate, a high cost polishing process is not necessary, and a problem of low yield due to high defect density can be solved, thereby improving economic feasibility.

Fourth, in the case of using an INVAR alloy for a flexible substrate of the present invention, a thermal expansion coefficient may be adjusted to a similar level in comparison with an inorganic semiconductor such as Si, SiO₂, and SiN and insulator. Therefore, it is not necessary to change a process condition such as a temperature increase rate or a temperature decrease rate, thereby reducing cracks caused by a thermal expansion coefficient difference.

Fifth, according to the flexible electronic device manufacturing method of the present invention, in which a temporary substrate for supporting a flexible substrate is used, an existing glass substrate process and existing equipment can be used without experiencing problems of bending, transporting, and alignment of a substrate, thereby facilitating a handling operation.

Sixth, since a mother substrate has a roll shape, deposition and exfoliation of a flexible substrate can be performed using a roll-to-roll process. Further, a flexible substrate can be transported, while being wound around the roll-type mother substrate. Moreover, processes of producing and transporting a substrate and forming an electronic device may be successively performed, as necessary, thereby improving a production rate and economic feasibility.

### [Description of Drawings]

The above and other aspects, features and other advantages of the present invention will be more clearly understood from the following detailed description taken in conjunction with the accompanying drawings, in which:

Figs. 1 to 5 are diagrams illustrating a method of manufacturing a flexible electronic device according to a first embodiment of the present invention;

Figs. 6 to 8 are diagrams illustrating a method of manufacturing a flexible electronic device according to a second embodiment of the present invention, and an exfoliation form when an exfoliation layer is formed between a flexible substrate and a roll-type mother substrate; and

Figs. 9 to 14 are diagrams illustrating a method of manufacturing a flexible electronic device according to a third embodiment of the present invention.

### [Best Mode]

Exemplary embodiments of the present invention will now be described in detail with reference to the accompanying drawings.

It should be understood that the terms or definitions used herein should not be construed as limited to general and dictionary meanings, but interpreted based on the meanings and ideas corresponding to the technical concept of the present invention, considering that inventors may appropriately define terms in order to describe inventions in the best way.

Therefore, the embodiments disclosed herein and the configurations illustrated in the drawings are merely examples, and do not represent the entire technical concept of the present invention. Thus, it should be understood that various equivalents and modifications could be made without departing from the spirit and scope of the present invention, and the present invention is not limited to the embodiments described below.

Rather, these embodiments are provided so that this disclosure will be thorough and complete, and will fully convey the scope of the present invention to those skilled in the art. The dimensions of the layers or regions in the drawings are exaggerated for clarity of illustration.

[First Embodiment]

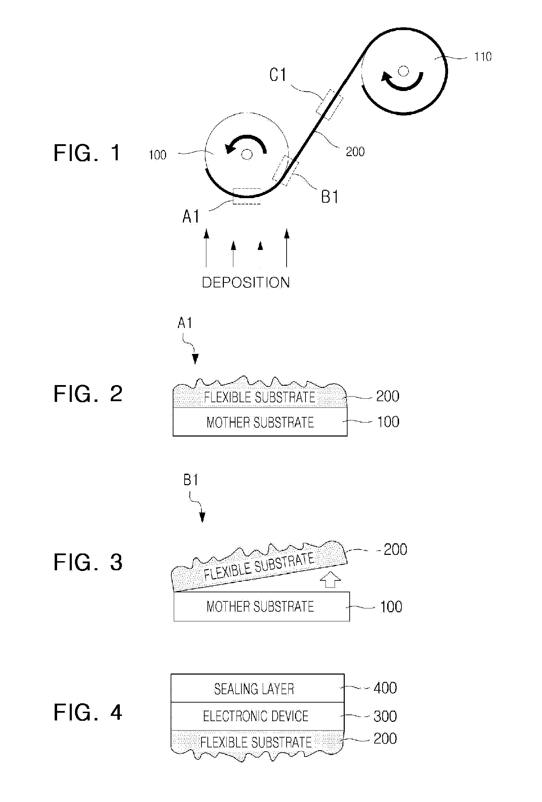

Figs. 1 to 5 are schematic diagrams illustrating a method of manufacturing a flexible electronic device according to a first embodiment of the present invention.

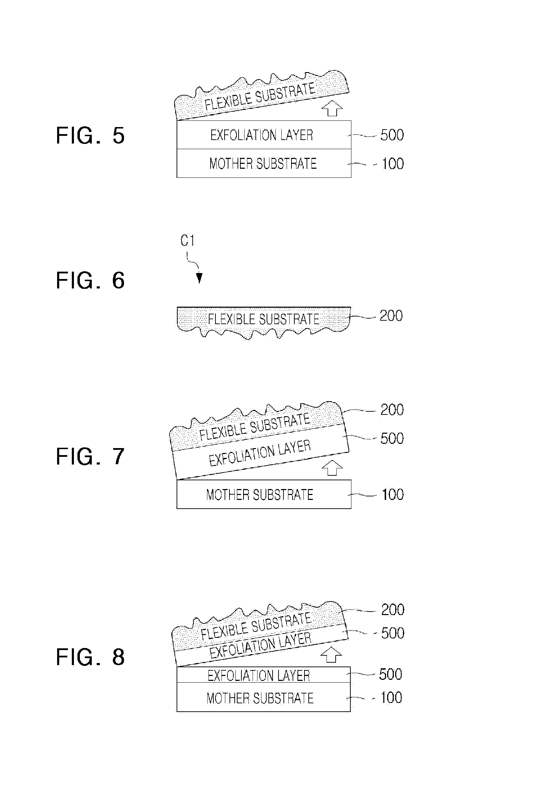

Referring to Figs. 1 to 5, the method of manufacturing a flexible electronic device, according to the first embodiment of the present invention, includes forming a flexible substrate 200 on a roll-type mother substrate 100 (A1 of Fig. 1 and Fig. 2), manufacturing the flexible substrate by separating the flexible substrate 200 from the roll-type mother substrate 100 (B1 of Fig. 1 and Fig. 3, and C1 of Fig. 1 and Fig. 4), and forming an electronic device 300 and a sealing layer 400 on a separation surface of the flexible substrate 200 (Fig. 5).

In the first embodiment of the present invention, a stainless rod, a mirror-finished surface of which has surface roughness of Rms < 100 nm and Rp-v < 1000 nm, is used as the roll-type mother substrate 100, and the flexible substrate 200 is formed by performing electroplating with Cu to a thickness of about 15 µm, and then the flexible substrate 200 is wound around a carrier roll 110.

Thereafter, an organic light-emitting display (OLED) device is formed on a separation surface of the flexible substrate 200 separated from the roll-type mother substrate 100. To form the OLED device, a pattern is formed by using photoresist, a reflective electrode is formed with Ag on the Cu flexible substrate to a thickness of about 100 nm, a hole injection layer is formed with CuO to a thickness of about 1 nm, a hole transport layer is formed with a-NPD on the hole injection layer to a thickness of about 70 nm, a light-emitting layer is formed with Alq₃ on the hole transport layer to a thickness of about 40 nm, a hole prevention layer is formed with BCP on the light-emitting layer to a thickness of about 5 nm, an electron transport layer is formed with Alq₃ on the hole prevention layer to a thickness of about 20 nm, and a transparent electrode is formed with Al on the electron transport layer to a thickness of about 10 nm. In this manner, a flexible OLED may be manufactured.

### [Mode for Invention]

[Second Embodiment]

As illustrated in Figs. 6 to 8, in a second embodiment of the present invention, an exfoliation layer 500 is formed between the roll-type substrate 100 and the flexible substrate 200 to manufacture the flexible substrate 200. In the case of forming the exfoliation layer 500, the flexible substrate 200 may be separated at an interface of the substrate 200 as illustrated in Fig. 6, may be separated at an interface between the roll-type mother substrate 100 and the exfoliation layer 500 as illustrated in Fig. 7, or may be separated at an inner side of the exfoliation layer 500 as illustrated in Fig. 8. Here, in the case of Fig. 6, an additional process may not be necessary. However, in the case of Figs. 7 and 8, a process of removing the exfoliation 500 may be added.

In the second embodiment of the present invention, similarly to the first embodiment, the roll-type mother substrate 100 is physically separated from the flexible substrate 200 by using low interfacial bonding strength in the exfoliation layer 500 and the flexible substrate 200. However, other methods may be used, for example, only the exfoliation layer 500 may be chemically removed by using acid or an alkaline solvent, or a laser may be irradiated onto materials of the exfoliation layer to decompose the exfoliation layer, wherein the materials have a smaller band gap in comparison with a wavelength of the laser. Here, the method of physically separating the roll-type mother substrate 100 from the flexible substrate 200 by using low interfacial bonding strength of the roll-type mother substrate 100 and the flexible substrate 200 may be used since additional chemical materials and relatively expensive laser radiation equipment are not necessary.

In the second embodiment of the present invention, an ITO layer is formed as the exfoliation layer to a thickness of about 120 nm on the roll-type glass substrate 100, then a Ti layer is formed as an underlayer for forming an INVAR layer to a thickness of about 50 nm and an Au layer is formed as a seed layer to a thickness of about 100 nm, then a Ti/Au/INVAR flexible substrate including the INVAR layer with a thickness of about 40 µm is formed, and then the Ti/Au/INVAR layer of the flexible substrate is physically separated from the glass substrate/ITO layer.

[Third Embodiment]

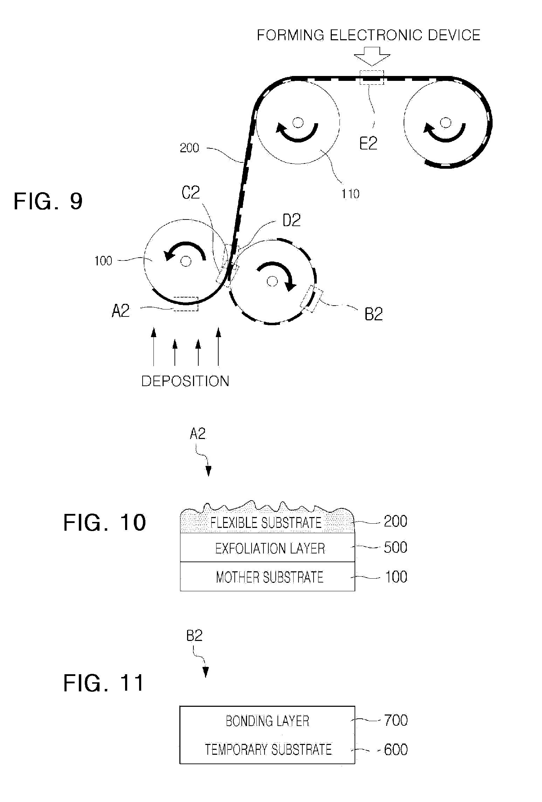

Figs. 9 to 14 are schematic diagrams illustrating a method of manufacturing a flexible electronic device according to a third embodiment of the present invention.

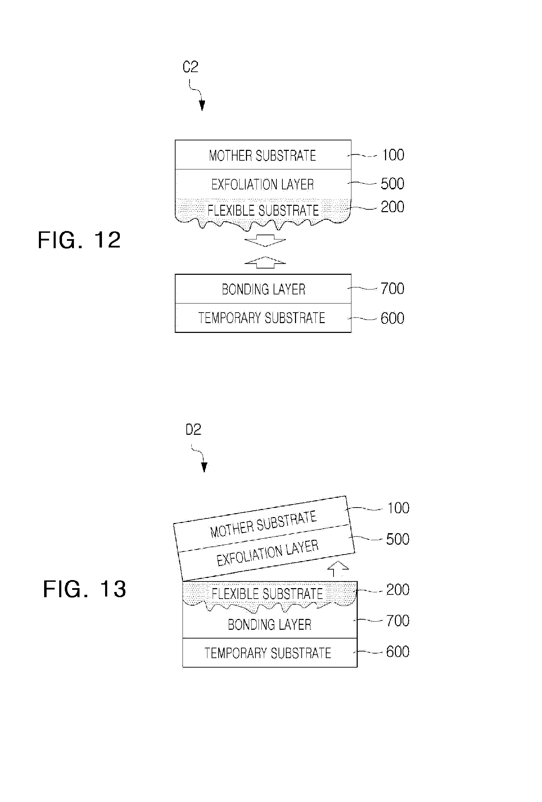

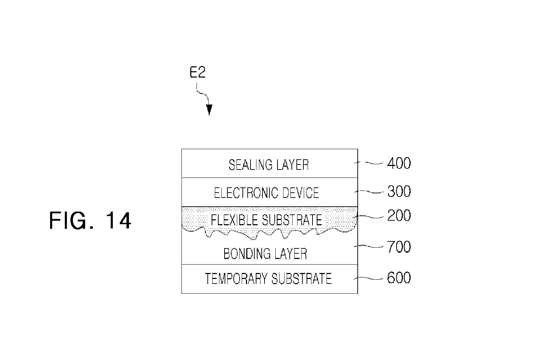

Referring to Figs. 9 to 14, in the method of manufacturing a flexible electronic device, according to the third embodiment of the present invention, the flexible substrate 200 is deposited on the roll-type mother substrate 100 (A2 of Fig. 9 and Fig. 10), and then a bonding layer 700 is interposed thereon to bond a temporary substrate 600 to the flexible substrate 200 (B2 of Fig. 9 and Fig. 11, and C2 of Fig. 9 and Fig. 12). Thereafter, the roll-type mother substrate 100 is separated from the flexible substrate 200 (D2 of Fig. 9 and Fig. 13), and an electronic device 300 and sealing layer 400 are formed on a separation surface of the flexible substrate 200 to manufacture a flexible electronic device (E2 of Fig. 9 and Fig. 14).

That is, the third embodiment is different from the first embodiment in that the temporary substrate 600 for handling the flexible substrate 200 is used. According to use of the temporary substrate 600, the temporary 600 may remain or may be separated. In the case of separating the temporary substrate 600, a separation layer may additionally be formed between the bonding layer 700 and the temporary substrate 600.

In detail, an Ag flexible substrate is formed to a thickness of about 5 µm on a glass substrate that is the roll-type mother substrate 100 by using a thermal deposition method. An epoxy adhesive is applied thereto, and then a PET substrate that is the temporary substrate 600 is bonded. Thereafter, the epoxy adhesive is hardened at a temperature of about 80 °C for about one hour, and then the Ag flexible substrate is physically separated from the glass substrate.

An OLED device is formed on a separation surface of the flexible substrate 200 separated from the glass substrate. To form the OLED device, a pattern is formed by using photoresist (PR), a hole injection layer is formed with CuO to a thickness of about 1 nm using the Ag flexible substrate as a reflective electrode, a hole transport layer is formed with a-NPD on the hole injection layer to a thickness of about 70 nm, a light-emitting layer is formed with Alq₃ on the hole transport layer to a thickness of about 40 nm, a hole prevention layer is formed with BCP on the light-emitting layer to a thickness of about 5 nm, an electron transport layer is formed with Alq₃ on the hole prevention layer to a thickness of about 20 nm, and a transparent electrode is formed with Al on the electron transport layer to a thickness of about 10 nm.

While the present invention has been shown and described in connection with the exemplary embodiments, it will be apparent to those skilled in the art that modifications and variations can be made without departing from the spirit and scope of the invention as defined by the appended claims.

## Claims

1. A method of manufacturing a flexible electronic device, the method comprising:
forming a flexible substrate on a roll-type mother substrate;
separating the flexible substrate from the roll-type mother substrate; and
forming an electronic device on a separation surface of the flexible substrate, which has contacted the roll-type mother substrate.

2. A method of manufacturing a flexible electronic device, the method comprising:
forming a flexible substrate on a roll-type mother substrate;
bonding a temporary substrate to the flexible substrate by using a bonding layer, the bonding layer being formed on one surface of the temporary substrate;
separating the flexible substrate from the roll-type mother substrate; and
forming an electronic device on a separation surface of the flexible substrate, which has contacted the roll-type mother substrate.

3. The method of any one of claims 1 and 2, wherein an exfoliation layer is additionally formed between the flexible substrate and the roll-type mother substrate.

4. The method of any one of claims 1 and 2, wherein a planarizing layer is additionally formed between the flexible substrate and the roll-type mother substrate.

5. The method of claim 3, wherein a planarizing layer is additionally formed on one or both surfaces of the exfoliation layer.

6. The method of claim 2, wherein a separation layer is formed between the temporary substrate and the bonding layer.

7. The method of claim 2, further comprising separating the temporary substrate from the flexible substrate.

8. The method of any one of claims 1 and 2, wherein surface roughness of a surface of the roll-type mother substrate, on which the flexible substrate is formed, is 0 < Rₘₛ < 100 nm and 0 < Rₚ₋ᵥ < 1000 nm when measured with a scan range of 10 µm × 10 µm by using an atomic force microscope (AFM).

9. The method of any one of claims 1 and 2, wherein the roll-type mother substrate is composed of glass, metal, or polymeric materials.

10. The method of any one of claims 1 and 2, wherein the flexible substrate has a composite structure in which two or more different materials are stacked.

11. The method of any one of claims 1 and 2, wherein the flexible substrate is composed of metal.

12. The method of claim 11, wherein the flexible substrate is composed of at least one metal selected from the group consisting of Fe, Ag, Au, Cu, Cr, W, Al, W, Mo, Zn, Ni, Pt, Pd, Co, In, Mn, Si, Ta, Ti, Sn, Zn, Pb, V, Ru, Ir, Zr, Rh, Mg, INVAR, and stainless steel.

13. The method of claim 2, wherein the bonding layer comprises at least one polymeric adhesive selected from the group consisting of epoxy, silicon, and acrylic group.

14. The method of claim 4, wherein the planarizing layer comprises at least one polymeric compound selected from the group consisting of polyimide (PI) or a copolymer comprising PI, polyacrylic acid or a copolymer comprising polyacrylic acid, polystyrene or a copolymer comprising polystyrene, polysulfate or a copolymer comprising polysulfate, polyamic acid or a copolymer comprising polyamic acid, polyamine or a copolymer comprising polyamine, polyvinylalcohol (PVA), polyallyamine, and polyacrylic acid.

15. The method of claim 5, wherein the planarizing layer comprises at least one polymeric compound selected from the group consisting of polyimide (PI) or a copolymer comprising PI, polyacrylic acid or a copolymer comprising polyacrylic acid, polystyrene or a copolymer comprising polystyrene, polysulfate or a copolymer comprising polysulfate, polyamic acid or a copolymer comprising polyamic acid, polyamine or a copolymer comprising polyamine, polyvinylalcohol (PVA), polyallyamine, and polyacrylic acid.

16. The method of any one of claims 1 and 2, wherein the flexible substrate is formed through a casting process, an electron-beam evaporation process, a thermal deposition process, a sputter deposition process, a chemical vapor deposition process, or an electroplating process.

17. The method of any one of claims 1 and 2, wherein the electronic device is at least one selected from the group consisting of an organic light-emitting display (OLED), a liquid crystal display (LCD), an electrophoretic display (EPD), a plasma display panel (PDP), a thin-film transistor (TFT), a microprocessor, and a random access memory (RAM).

18. The method of claim 2, wherein the bonding layer comprises at least one material selected from the group consisting of SiO₂, MgO, ZrO₂, Al₂O₃, Ni, Al, and mica, and a using temperature of the bonding layer is about 450 °C or above.

19. A flexible electronic device manufactured by the method of any one of claims 1 and 2.

20. A flexible substrate using a separation surface as a forming surface of an electronic device, wherein the separation surface is obtained by forming the flexible substrate on a roll-type mother substrate and then separating the flexible substrate from the roll-type substrate.

21. The flexible substrate of claim 20, wherein surface roughness of the separation surface is, without undergoing a polishing process, 0 < Rₘₛ < 100 nm and 0 < Rₚ₋ᵥ < 1000 nm when measured with a scan range of 10 µm × 10 µm by using an atomic force microscope (AFM).

22. The flexible substrate of any one of claims 20 and 21, wherein the flexible substrate is composed of metal.

23. The flexible substrate of claim 22, wherein the metal is an INVAR alloy or stainless steel.

24. The flexible substrate of any one of claims 20 and 21, wherein the flexible substrate is formed to a thickness of about 1 µm to about 500 µm.

25. The flexible substrate of any one of claims 20 and 21, wherein the electronic device is at least one selected from the group consisting of an organic light-emitting display (OLED), a liquid crystal display (LCD), an electrophoretic display (EPD), a plasma display panel (PDP), a thin-film transistor (TFT), a microprocessor, and a random access memory (RAM).
